# EUROPEAN PATENT APPLICATION

(11) **EP 4 841 290 A1**
(43) Date of publication of application: **18.11.2026**
(21) Application number: 25176074.0
(22) Date of filing: 13.05.2025
(51) Int. Cl.: G01R 33/48, G01R 33/54, G01R 33/561

(54) **PARAMETERIZING A GRADIENT ECHO DATA ACQUISITION IN MAGNETIC RESONANCE IMAGING**

(71) Applicant: Siemens Healthineers AG, 91301 Forchheim (DE)
(72) Inventor: Buonincontri, Guido, 50059 Vinci (IT); Polak, Daniel, 91052 Erlangen (DE)
(74) Representative: Siemens Healthineers Patent Attorneys

(57) **Abstract**

For parameterizing a GRE data acquisition in MRI, a data acquisition shot structure (17), a first a second set of parameters (18b) for parameterizing the data acquisition shot structure (17) at a k-space center and a k-space edge, respectively, are received. A transition function (20, 27, 27') from the first to the second set of parameters (18b) is computed, which assigns a set of parameters to each of a plurality of k-space segments to be sampled according to a transition scheme (19). The transition function (20, 27, 27') assigns the first set of parameters (18a) to the k-space center and the second set of parameters (18b) to the k-space edge. A pulse sequence (21) is generated, which comprises data acquisition shots (23a, 23b, 23c, 23d) to sample the plurality of k-space segments according to the data acquisition shot structure (17) parameterized according to the transition function (20, 27, 27').

## Description

The present disclosure relates to a computer-implemented method for parameterizing a gradient echo (GRE) data acquisition in magnetic resonance imaging (MRI). Furthermore, the present disclosure relates to a method for controlling an MRI system to carry out a GRE data acquisition. The present invention also relates to a corresponding data processing system, MRI system, and computer program product.

Magnetic resonance imaging has become an indispensable tool in medical diagnostics, providing detailed images of internal body structures without the use of ionizing radiation. Over the past decades, significant advancements have been made in MRI technology, particularly in the realm of pulse sequences and data acquisition techniques. Gradient echo sequences have emerged as a versatile class of MRI pulse sequences, offering rapid imaging capabilities and flexibility in contrast manipulation. GRE sequences can be tailored to produce different tissue contrasts by adjusting acquisition parameters such as flip angle, TE, and TR.

Despite the numerous advantages of GRE sequences, challenges remain in optimizing image quality while maintaining reasonable scan times. One of the primary difficulties lies in balancing the trade-off between signal-to-noise ratio (SNR), contrast-to-noise ratio (CNR), and spatial resolution. Not all regions of k-space contribute equally to the image. The central region of k-space primarily determines contrast, whereas the outer region defines image sharpness. Conventional GRE sequences employ uniform parameter settings across the entire k-space, which may not be optimal for capturing both contrast information in the center of k-space and high-frequency details at the periphery.

Especially in T1-weighted magnetization-prepared 3D acquisitions (such as MP-RAGE), the time between the execution of the different GRE trains, also known as dead time TD, is relatively long, leading to a long overall acquisition time.

It is an objective of the present invention to overcome said drawbacks at least in part.

This objective is achieved by the subject matter of the independent claims. Further implementations and preferred embodiments are subject matter of the dependent claims.

The invention is based on the idea to compute a transition function specifying a continuous transition from a first set of parameters provided for the k-space center to a second set of parameters provided for a k-space edge. The transition function is used to generate a pulse sequence for controlling an MRI system accordingly to carry out a GRE data acquisition.

According to a first aspect of the invention, a computer-implemented method for parameterizing a gradient echo data acquisition in magnetic resonance imaging is provided. The computer-implemented method includes receiving a predefined data acquisition shot structure for GRE data acquisition, receiving a first set of parameters for parameterizing the data acquisition shot structure in a k-space center, and receiving a second set of parameters for parameterizing the data acquisition shot structure at a k-space edge. The computer-implemented method further includes computing a transition function, which specifies a continuous transition from the first set of parameters to the second set of parameters, in particular depending on the first set of parameters and the second set of parameters, wherein the transition function assigns a respective set of parameters for parameterizing the data acquisition shot structure to each k-space segment of a plurality of k-space segments to be sampled, wherein the transition function is computed according to at least one predefined transition scheme. The transition function is computed such that the transition function assigns the first set of parameters to a k-space segment corresponding to the k-space center and the transition function assigns the second set of parameters to a k-space segment corresponding to the k-space edge. A pulse sequence for controlling an MRI system to carry out the GRE data acquisition is generated, the pulse sequence comprising a plurality of data acquisition shots, each data acquisition shot of the plurality of data acquisition shots being designed to sample at least one k-space segment of the plurality of k-space segments according to the data acquisition shot structure parameterized according to the transition function.

Unless stated otherwise, all steps of the computer-implemented method may be performed by a data processing system, which comprises at least one data processing device. In particular, the at least one data processing device is configured or adapted to perform the steps of the computer-implemented method. For this purpose, the at least one data processing device may for example store a computer program comprising instructions which, when executed by the at least one data processing device, cause the at least one data processing device to execute the computer-implemented method. The expressions "data processing system" and "at least one data processing device" may be used interchangeably, here and in the following. This holds also for respective expressions derived therefrom.

In case the at least one data processing device comprises two or more data processing devices, certain steps carried out by the at least one data processing device may also be understood such that different data processing devices carry out different steps or different parts of a step. In particular, it is not required that each data processing device carries out the steps completely. In other words, carrying out the steps may be distributed amongst the two or more data processing devices.

As used herein, the term k-space segment may refer to a portion or subdivision of k-space. A k-space segment may include one or more k-space lines, where a k-space line represents a single row or column of data points in k-space, typically along the frequency encoding direction. A k-space segment may also refer to a k-space partition, which may be a single row or column of data points along the slice-selection direction. k-space segments may also be 1D-curves that are not straight, such as spirals. k-space segments may also be 2D-portions or subdivisions of k-space. k-space segments may be defined based on their distance from the center of k-space, their spatial frequency content, or other criteria relevant to the imaging sequence and reconstruction method being used. The k-space segments may sometimes also be denoted as k-space indices and/or may for example be identified by one or more numerical indices, respectively.

The first and the second set of parameters may, for example, be provided by a user, in particular via a user interface, or may be predefined. They may also be calculated, for example by using data of a patient to be examined. Thus, differently from the conventional sequence parameterization, one parameterization, namely the first set of parameters, is defined in the k-space center and a different one, namely the second set of parameters, is defined in the k-space edges. This may, for example, be done by selecting a target contrast in the k-space center, for example defined by a prescribed contrast information, and a target contrast in the k-space edge, again preferably dictated by a different set of parameter values.

The sets of parameters for parameterizing the data acquisition shot structure including the first and the second set of parameters may, in particular, comprise at least one timing parameter for the comprise timing information for the data acquisition shot structure such as, for example echo time TE, repetition time TR, echo spacing, and/or flip angles of excitation pulses and/or refocusing pulses. In particular, the first set of parameters, the second set assigned by the transition function to each k-space segment of the plurality of k-space segments may for example all concern the same parameters as such but may have different values for those parameters.

A data acquisition shot structure may refer to a predefined arrangement or pattern of data acquisition events within a magnetic resonance imaging sequence corresponding to one or more data acquisition shots. This structure may include the timing, order, and/or parameters of radiofrequency (RF) pulses, gradient applications, and/or signal readouts that comprise a single repetition or a group of repetitions. The data acquisition shot structure may define how k-space is sampled during the imaging process, including aspects such as the trajectory through k-space, the number of echoes acquired per excitation, and the spatial encoding scheme used. In some cases, the data acquisition shot structure may be tailored to optimize specific imaging characteristics such as contrast, resolution, or acquisition speed for different regions of k-space. The data acquisition shot structure is designed to realize a GRE data acquisition.

A data acquisition shot structure does, however, not define the values of the set of parameters defined by the first set of parameters, the second set of parameters and the transition function. In other words, the combination of the data acquisition shot structure and a respective set of parameters for parameterizing the data acquisition shot structure, in particular assigned by the transition function, fully defines the respective one or more data acquisition shot such that the pulse sequence may be generated accordingly. In other words, the pulse sequence corresponds to the plurality of data acquisition shots to be sampled, wherein all required parameters, including those assigned by the transition function, are fixed.

The term k-space center may refer to the origin of the k-space. The k-space segment corresponding to the k-space center is, in particular, a k-space segment, which includes the k-space center.

The term k-space edge may refer to a peripheral region or point of k-space, in particular to a region or point of k-space, furthest from the origin, which is still to be sampled. The k-space segment corresponding to the k-space edge is, in particular, a k-space segment, which includes the k-space edge. Different k-space edges, for example all k-space edges, may be treated identically by the transition function, meaning that the transition function assigns the same second set of parameters to al k-space segments corresponding to any k-space edge. However, in alternative embodiments, different sets of parameters may be assigned to different k-space edges. The different sets of parameters for different k-space edges may also be predefined.

The transition specified by the transition function may be a continuous transition in the sense that it assigns a respective set of parameters to each point in k-space from the k-space center to the k-space edge, wherein the k-space points are discrete points. The transition function may, for example, be a function of a distance, in particular radial distance, from the k-space center. The transition function may also be a function of one or more k-space indices, wherein each k-space segment to be sampled is uniquely defined or identified by one or more respective k-space indices. The one or more k-space indices are, for example, respective numerical values defining the position or coordinate of the respective k-space segment in k-space.

In case the set of parameters for parameterizing the data acquisition shot structure comprises two or more parameters, the transition function is, in particular, a multi-dimensional function meaning that it assigns two or more respective values to each k-space segment.

The transition scheme may refer to a predefined scheme or rule set that governs how the parameter values change between different regions of k-space. The transition scheme may specify the mathematical function, algorithm, or pattern used to interpolate or calculate parameter values for k-space segments between the center and edge of k-space. Possible transition schemes may include linear, polynomial, exponential, or other mathematical relationships that define how parameters transition from one set of values to another across k-space. In some cases, different transition schemes may be employed for different parameters or different regions of k-space.

The computer-implemented method according to the invention allows for individually parameterized echoes in gradient echo sequences, enabling optimization of different k-space regions for improved image quality and acquisition efficiency. By using different parameters for different parts of k-space, the method can achieve a better trade-off between different quality measures such as signal-to-noise ratio, contrast-to-noise ratio, T1-induced blurring, et cetera.

The generated pulse-sequence may for example be output to the MRI system for the application of corresponding RF-pulses and magnetic pulses such as gradients for an examination. It should be noted that it is not necessary that the pulse-sequence is applied immediately, it may also be saved as a dataset in a memory and be fed to an MRI-system later. Such dataset may also be applied several times for several examinations.

In at least one embodiment, the first set of parameters, the second set of parameters, and the set of parameters assigned by the transition function to the plurality of k-space segments comprise at least one respective timing parameter for the data acquisition shot structure.

The inclusion of timing parameters allows for fine-tuning of the acquisition process, potentially leading to improved image contrast and/or improved image quality and/or reduced scan times.

In at least one embodiment, the at least one timing parameter comprises at least one echo time TE, and/or a repetition time TR, and/or an inversion time TI, and/or a dead time TD, and/or an echo train time corresponding to an echo train length.

These specific timing parameters provide a comprehensive set of tools for optimizing the GRE sequence, allowing for precise control over image contrast and quality as well as acquisition speed.

It is noted that not all of said timing parameters are necessarily independent of each other. In this case, timing parameters that depend on each other may be assigned consistently.

In at least one embodiment, the first set of parameters, the second set of parameters, and the set of parameters assigned by the transition function to the plurality of k-space segments comprise at least one respective flip angle, and/or at least one respective number of echoes corresponding to an echo train length.

The ability to adjust flip angles and the number of echoes for different k-space regions enables further optimization of signal intensity and contrast, potentially leading to improved image quality.

It is noted that not all of said parameters are necessarily independent of each other. In this case, parameters that depend on each other may be assigned consistently.

In at least one embodiment, the at least one predefined transition scheme comprises a linear transition scheme or a polynomial transition scheme, in particular an at least quadratic or at least cubic transition scheme, or an exponential transition scheme.

These various transition schemes provide flexibility in how parameters change across k-space, allowing for smooth transitions that can be tailored to specific imaging requirements.

For example, a linear transition scheme for a parameter P may for example be expressed as: $P \left(k\right) = {P}_{c} + \left({P}_{e}-{P}_{c}\right) ⋅ \frac{\left|k\right|}{{k}_{max}}$ where P_{c} is the parameter value at the k-space center, Pₑ is the parameter value at the k-space edge, |k| is the distance from the k-space center, and kₘₐₓ is the maximum k-space distance.

A polynomial transition scheme may for example be represented by: $P \left(k\right) = {P}_{c} + \left({P}_{e}-{P}_{c}\right) ⋅ {\left(\frac{\left|k\right|}{{k}_{max}}\right)}^{n}$ where n is the degree of the polynomial, for example n=2 for quadratic, n=3 for cubic, et cetera.

An exponential transition scheme may, for example, be described by: $P \left(k\right) = \frac{{P}_{e} - {P}_{c} ⋅ {e}^{- α} + \left({P}_{c}-{P}_{e}\right) ⋅ {e}^{- α \left|k\right| / {k}_{max}}}{1 - {e}^{- α}}$ where α is a predefined, for example positive, parameter controlling the rate of transition.

These formulas may also be adapted or combined to create more complex transition schemes tailored to specific imaging requirements or k-space characteristics.

In at least one embodiment, an intermediate set of parameters for parameterizing the data acquisition shot structure at an intermediate k-space segment, which is different from the k-space center and different from the k-space edge, is received. The transition function is computed to specify a transition from the first set of parameters to the intermediate set of parameters and from the intermediate set of parameters to the second set of parameters such that the transition function assigns the intermediate set of parameters to the intermediate k-space segment.

This feature allows for more complex parameter variations across k-space, potentially enabling even finer control over image characteristics in different k-space regions.

The intermediate k-space segment is, in particular, a predefined intermediate k-space segment of the plurality of k-space segments to be sampled. The intermediate set of parameters may, for example, be provided by a user, in particular via a user interface, or may be predefined.

In at least one embodiment, each k-space segment of the plurality of k-space segments is a k-space line along a frequency encoding direction of the k-space.

In other words, denoting the frequency encoding direction by x, the phase encoding direction by y and the slice selection direction by z, the k-space segments are straight lines parallel to the x-direction. Each k-space segment may therefore be identified by a coordinate tuple (y, z) in the y-z-plane. The coordinate tuples correspond to said k-space indices since the coordinates in k-space are discrete. The transition function may therefore be a function of (y, z), for example a function of the radius $\sqrt{{y}^{2} + {z}^{2}}$.

The transition function may, however, also be a function of y and independent of z or may be a function of z and independent of y.

The transition function may also be a function of a polar angle in the y-z-plane of the k-space perpendicular to the frequency encoding direction x. The transition function may also be a function of the polar angle and the radius or a function of the polar angle and the z-coordinate or a function of the polar angle and the y-coordinate.

Defining k-space segments along the frequency encoding direction allows for efficient data acquisition and straightforward implementation of the variable parameter scheme.

In at least one embodiment, a third set of parameters for parameterizing the data acquisition shot structure at a further k-space edge is received. The transition function is computed to specify a transition from the second set of parameters to the third set of parameters or from the first set of parameters to the third set of parameters, wherein the transition function assigns the third set of parameters to a k-space segment corresponding to the further k-space edge.

This feature allows for even more complex parameter variations across k-space, potentially enabling optimization of multiple k-space regions with different characteristics.

In at least one embodiment, the transition assigns a first parameter of the respective set of parameters to each k-space segment of the plurality of k-space segments according to a first transition scheme of the at least one predefined transition scheme, and the transition assigns a second parameter of the respective set of parameters to each k-space segment of the plurality of k-space segments according to a second transition scheme of the at least one predefined transition scheme, wherein the second transition scheme is different from the first transition scheme.

This allows for independent control of different parameters across k-space, potentially enabling more sophisticated optimization strategies.

According to a second aspect of the invention, a method for controlling an MRI system to carry out a GRE data acquisition is provided. The method includes carrying out the computer-implemented method according to the first aspect and controlling the MRI system to apply the pulse sequence.

Controlling the MRI system to generate the pulse sequence comprises, in particular, controlling gradient coils and/or RF coils and/or respective amplifiers and/or further components of the MRI system such that the pulse sequence is applied or output, respectively, to an examination region of the MRI system, in particular a region in the bore of the MRI system, where an object or patient to be examined may be placed, to generate MRI data representing or imaging the object or patient.

According to a third aspect of the invention, a data processing system adapted to carry out the computer-implemented method according to the first aspect is provided.

In the present disclosure, the terms "data processing system" and "at least one data processing device" can be used interchangeably. In particular, a data processing device can be understood to mean a data processing device that contains a processing circuit. The data processing device can therefore, in particular, process data for the purpose of performing computing operations. This may also include operations for performing indexed access to a data structure, for example a look-up table, LUT, as well as a data processing method implemented in hardware.

The data processing device may include, in particular, one or more computers, one or more microcontrollers and/or one or more integrated circuits, for example one or more application-specific integrated circuits, ASIC, one or more field-programmable gate arrays, FPGA, and/or one or more systems-on-a-chip, SoC. The data processing device may also include one or more processors, for example one or more microprocessors, one or more central processing units, CPUs, one or more graphics processing units, GPUs, and/or one or more signal processors, in particular one or more digital signal processors, DSPs. The data processing device may also include a physical or virtual network of computers or other of the mentioned units.

In various embodiments, the data processing device includes one or more hardware and/or software interfaces and/or one or more storage units.

A storage unit may be a volatile data memory, for example a dynamic random access memory, DRAM, or a static random access memory, SRAM, or a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a fourth aspect of the invention, an MRI system comprising the data processing system according to the third aspect and a controller configured to control the MRI system to apply the pulse sequence is provided. The controller may, for example, be part of the data processing system.

According to a fifth aspect of the invention, a computer program product comprising instructions is provided. When the instructions are executed by a data processing system, the instructions cause the data processing system to carry out a computer-implemented method according to the first aspect.

The instructions may be provided as program code, for example. The program code can for example be provided as binary code or assembler and/or as source code of a programming language, for example C, and/or as program script, for example Python.

The computer program product may, for example, be a computer program with the instructions or a computer-readable storage medium, in particular a tangible and/or non-transient computer readable storage medium, storing a computer program with the instructions.

According to a sixth aspect of the invention, a further computer program product comprising further instructions is provided. When the further instructions are executed by an MRI system according to the fourth aspect, the instructions cause the MRI system to carry out a method according to the second aspect.

The further instructions may be provided as program code, for example. The program code can for example be provided as binary code or assembler and/or as source code of a programming language, for example C, and/or as program script, for example Python.

The further computer program product may, for example, be a further computer program with the further instructions or a further computer-readable storage medium, in particular a tangible and/or non-transient further computer readable storage medium, storing a further computer program with the instructions.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,
FIG 1 shows a schematic representation of an exemplary embodiment of a magnetic resonance imaging system according to the invention;
FIG 2 shows a schematic flow diagram of an exemplary embodiment of a computer-implemented method for parameterizing a GRE data acquisition in MRI according to the invention;
FIG 3 shows schematically a timing diagram illustrating a sequence of data acquisition shots in MRI as a use case for a further exemplary embodiment of a computer-implemented method according to the invention;
FIG 4 shows schematically a timing diagram illustrating a sequence of data acquisition shots in MRI as a use case for a further exemplary embodiment of a computer-implemented method according to the invention;
FIG 5 shows schematically a timing diagram illustrating a sequence of data acquisition shots in MRI as a use case for a further exemplary embodiment of a computer-implemented method according to the invention; and
FIG 6 shows a graph illustrating exemplary transition functions according to further exemplary embodiments of a computer-implemented method according to the invention.

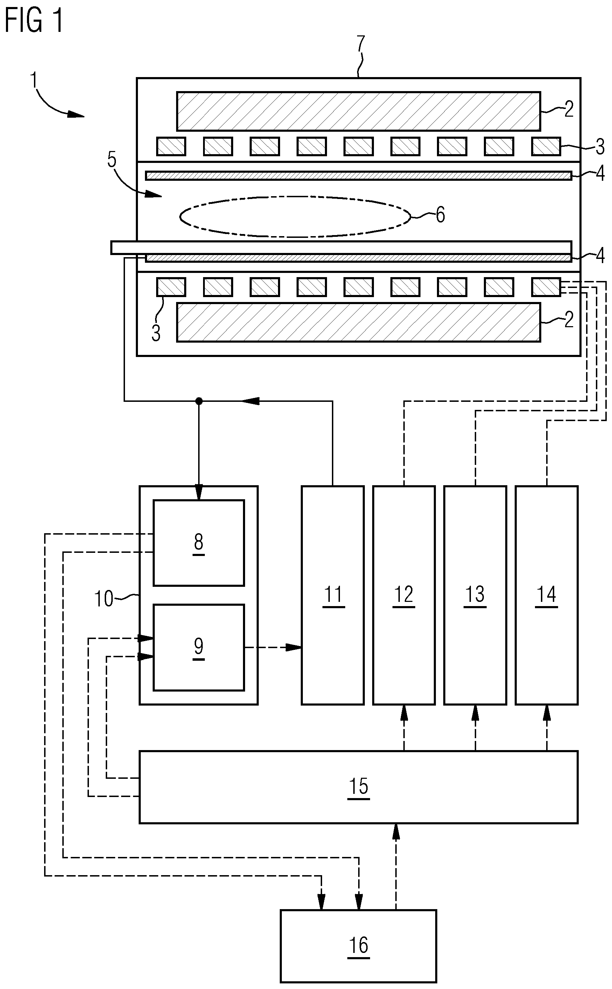

An exemplary embodiment of a MRI system 1 according to the invention is shown in FIG 1. The MRI system 1 includes a main magnet arrangement 2, a gradient coil arrangement 3, and at least one RF coil 4 arranged concentrically around a bore 5. A patient 6 can be positioned within the bore 5 for imaging. These components are, for example, housed within a magnet housing 7.

The main magnet arrangement 2 generates a strong, static magnetic field may be controlled to align the nuclear spins of the patient 6. The gradient coil arrangement 3 may be controlled produce spatially varying magnetic fields to encode spatial information into the MR signals. The at least one RF coil 4 may be controlled to transmit RF pulses to excite the nuclear spins and receives the resulting MR signals.

A data processing system 16 of the MRI system 1 is capable of carrying out a computer-implemented method for parameterizing a GRE data acquisition according to the invention to generate a pulse sequence 21 for controlling the MRI system 1 for GRE data acquisition.

The MRI system 1 may also include a user interface for configuring the GRE data acquisition parameters.

The MRI system 1 comprises an RF system 4, 10, 11 including the at least one RF coil 4, which is configured to apply RF pulses to the patient 6 and to receive MR signals emitted from the patient. For example, the main magnet arrangement 2 may generate a uniform main magnetic field B0 as the main magnetic field and the at least one RF coil 4 may emit an excitation field B1.

According to MR techniques, the patient 6 is subjected to the main magnetic field, causing the nuclear spins in the target material to precess about the direction of the main magnetic field at their characteristic Larmor frequency. A net magnetic moment Mz is produced in the direction z of the main magnetic field, and the randomly oriented magnetic moments of the nuclear spins cancel out one another in the x-y-plane.

When the patient 6 is then subjected to the transmit RF magnetic field, which is for example in the x-y plane and near the Larmor frequency, the net magnetic moment rotates out of the z-direction generating a net in-plane magnetic moment, whose projection rotates in the x-y plane with the Larmor frequency. In response, MR signals are emitted by the excited spins when they return to their state before the excitation. The emitted MR signals are detected, for example by the at least one RF coil 4 and/or one or more dedicated detection coils, digitized in a receiver channel 8 of an RF controller 10 of the RF system 4, 10, 11, and processed by the data processing system 16 to reconstruct an MR image using for example a known reconstruction technique.

In particular, the gradient coil arrangement 3 may produce magnetic field gradients Gx, Gy, and Gz for position-encoding of the MR signals. Accordingly, MR signals are emitted only by such nuclei of the patient 6, which correspond to the particular Larmor frequency. For example, Gz is used together with a bandwidth-limited RF pulse to select a slice perpendicular to the z-direction and consequently may also be denoted as slice selection gradient. In alternative example, Gx, Gy, and Gz may be used in any predefined combination with a bandwidth-limited RF pulse to select a slice perpendicular to the vector sum of said gradient combination. The gradient coil arrangement 3 may be supplied with current by respective amplifiers 12, 13, 14 for generating the respective gradient fields in x-direction, y-direction, and z-direction, respectively. Each amplifier 12, 13, 14 may include a respective digital-to-analog converter, which is controlled by a sequence controller 15 to generate respective gradient pulses at predefined time instances.

The sequence controller 15 may control the generation of RF pulses by an emitter channel 9 of the RF controller 12 and an RF power amplifier 11 of the RF system 4, 11, 12.

The data processing system 16 may receive the real and imaginary parts from analog-digital converters of the receiver channel 8 and reconstruct the MR image based on them according to a known technique.

It is noted that the components of the MRI system 1 can also be arranged differently from the arrangement shown in FIG 1. For example, the gradient coil arrangement 3 may be arranged inside the bore 5, similar as shown for the at least one RF coil 4.

It is further noted that each component of the MRI system 1 may include other elements which are required for the operation thereof, and/or additional elements for providing functions other than those described in the present disclosure.

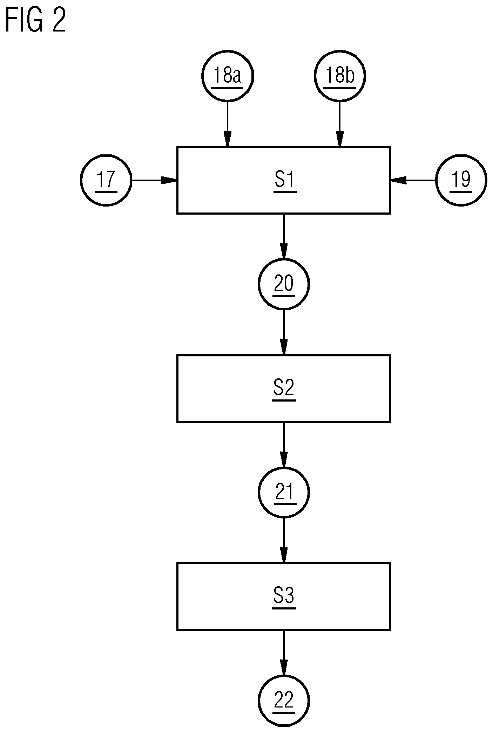

In particular, the data processing system 16 of the MRI system 1 carries out a computer-implemented method for parameterizing a GRE data acquisition. FIG 2 shows a schematic flow diagram of such a computer-implemented method (steps S1 and S2) and an application of the pulse sequence 21 (step S3).

In a first step S1, the data processing system 16 receives a predefined data acquisition shot structure 17 for GRE data acquisition as well as a predefined transition scheme 19. The data processing system 16 also receives a first set of parameters 18a for parameterizing the data acquisition shot structure in a k-space center and a second set of parameters 18b for parameterizing the data acquisition shot structure at a k-space edge.

The sets of parameters 18a, 18b may, for example, include timing parameters, flip angles, and/or other sequence-related variables that may, for example, be adjusted to optimize image contrast and quality.

The data processing system 16 computes a transition function 20, which specifies a transition from the first set of parameters 18a to the second set of parameters 18b, based on the first set of parameters 18a, the second set of parameters 18b, and the transition scheme 19. The transition function 20 assigns a respective set of parameters for parameterizing the data acquisition shot structure 17 according to the transition scheme 19 to each k-space segment of a plurality of k-space segments to be sampled. The transition function 20 is computed such that it assigns the first set of parameters 18a to a k-space segment corresponding to the k-space center and the second set of parameters 18b to a k-space segment corresponding to the k-space edge.

In a second step S2, the data processing system 16 generates the pulse sequence 21 for controlling the MRI system 1 to carry out the GRE data acquisition. The pulse sequence 21 comprises a plurality of data acquisition shots. Each data acquisition shot is designed to sample at least one of the plurality of k-space segments according to the data acquisition shot structure 17 parameterized according to the transition function 20.

In step S3, the sequence controller 15 and/or the data processing system 16 may control the MRI system 1 to apply the pulse sequence 21 to the patient 6 to generate MRI data 22.

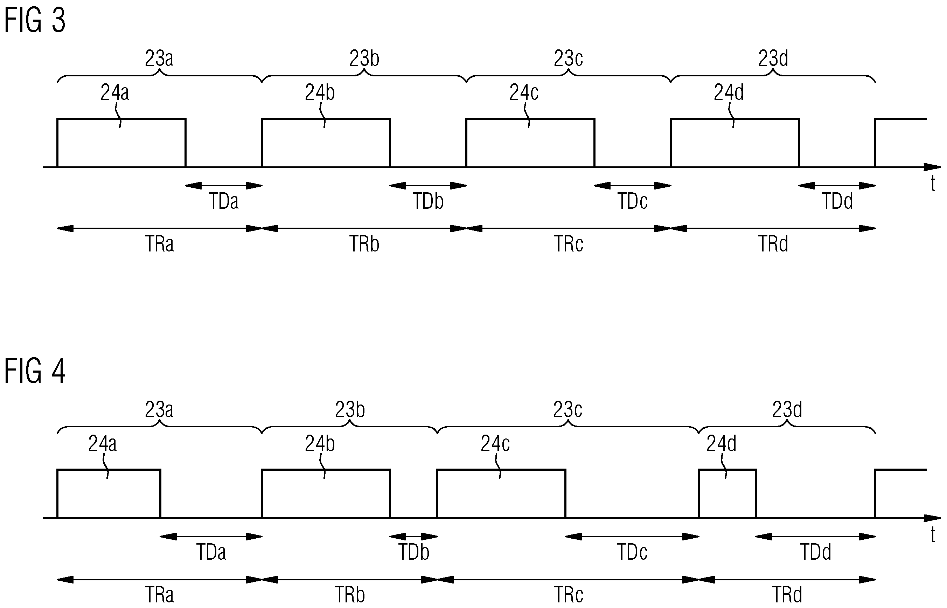

FIG 3, FIG 4 and FIG 5 illustrate respective exemplary sequences of data acquisition shots 24a, 24b, 24c, 24d for gradient echo GRE data acquisition.

Each data acquisition shot 24a, 24b, 24c, 24d is associated with at least one corresponding echo train 23a, 23b, 23c, 23d. The first data acquisition shot 24a includes a first echo train 23a, the second data acquisition shot 24b includes a second echo train 23b, the third data acquisition shot 24c includes a third echo train 23c, and the fourth data acquisition shot 24d includes a fourth echo train 23d.

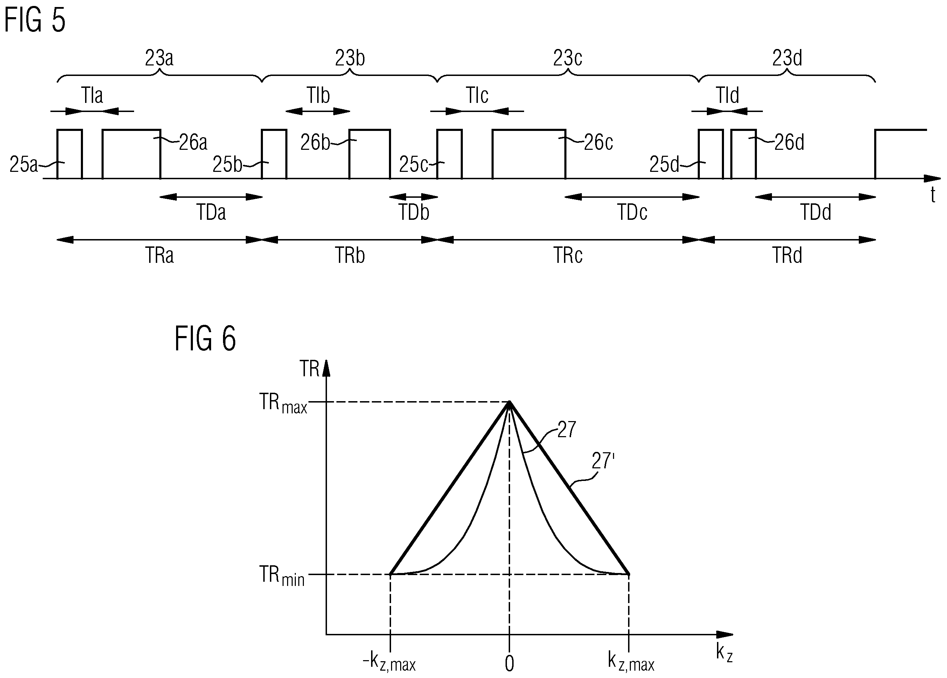

The data acquisition shot structure 17 inter alia allows for individually parameterized echo trains 23a, 23b, 23c, 23d within the same acquisition. This structure enables the MRI system 1 to optimize sequence parameters for different k-space regions, which may be particularly beneficial for T1-weighted magnetization-prepared 3D acquisitions such as MP-RAGE (Magnetization Prepared Rapid Gradient Echo), as indicated in FIG 5.

A first dead time TDa, a second dead time TDb, a third dead time TDc, and a fourth dead time TDd are intervals between the echo trains 23a, 23b, 23c, 23dof consecutive data acquisition shots 24a, 24b, 24c, 24d. The first dead time TDa follows the first data acquisition shot 24a, the second dead time TDb follows the second data acquisition shot 24b, the third dead time TDc follows the third data acquisition shot 24c, and the fourth dead time TDd follows the fourth data acquisition shot 24d.

Similarly, a first repetition time TRa, a second repetition time TRb, a third repetition time TRc, and a fourth repetition time TRd are associated with the first data acquisition shot 24a, the second data acquisition shot 24b, the third data acquisition shot 24c, and the fourth data acquisition shot 24d, respectively. These repetition times may be varied independently for different k-space regions according to the transition function20, allowing for customized timing across the k-space acquisition. Alternatively or in addition, the data processing system 16 may, for example, adjust each of the dead times TDa, TDb, TDc, TDd individually based on the transition function 20 to optimize the sequence for different k-space regions, as shown in FIG 4. Alternatively or in addition, the data processing system 16 may, for example, adjust respective echo trains 23a, 23b, 23c, 23d and/or flip angles et cetera within the echo trains 23a, 23b, 23c, 23d.

The pulse sequence 21 incorporates the individual parameters. This approach allows the MRI system 1 to adapt the acquisition parameters based on the specific k-space region being sampled, potentially improving the efficiency and quality of the resulting MRI data 22.

FIG 5 illustrates further examples how timing parameters can be individually adjusted for different parts of k-space. In particular, respective inversion times Tla, Tlb, Tlc, Tld associated with the respective data acquisition shots 24a, 24b, 24c, 24d may be varied according to the transition function 20, providing additional flexibility in sequence optimization. The inversion times Tla, Tlb, Tlc, Tld correspond, in particular, to respective time periods between a magnetization preparation module 25a, 25b, 25c, 25d and a GRE module 26a, 26b, 26c, 26d, of the respective data acquisition shots 24a, 24b, 24c, 24d.

The magnetization preparation modules 25a, 25b, 25c, 25d are, for example, designed to prepare the magnetization of the tissue being imaged before the actual data acquisition by the GRE modules 26a, 26b, 26c, 26d. The magnetization preparation modules 25a, 25b, 25c, 25d may include various RF pulses and gradient fields to achieve specific contrast properties in the resulting images. The GRE modules 26a, 26b, 26c, 26d are responsible for the actual data acquisition, generating the gradient echoes that form the basis of the MRI signal.

FIG 6 illustrates examples for the transition function 20, namely a linear transition function 27 of the repetition time TR as a function of k_{z} and an exponential transition function 27' of the repetition time TR as a function of k_{z}.

The transition function 27 has its maximum TRₘₐₓ in the k-space center k_{z} = 0 and decays linearly to the minimum TRₘᵢₙ at the k-space edges k_{z} = ±k_{z,max}. The transition function 27' also has its maximum TRₘₐₓ in the k-space center k_{z} = 0 and decays exponentially to the minimum TRₘᵢₙ at the k-space edges k_{z} = ±k_{z,max}.

By varying the repetition time according to the k-space position, the acquisition may be optimized for different regions of k-space. The longer repetition times in the center of k-space, where the transition functions 27, 27' peak, may allow for improved contrast and signal-to-noise ratio in the low spatial frequency information. Conversely, the shorter repetition times at the edges of k-space may enable faster acquisition of high spatial frequency information.

The use of such transition functions may result in T1-induced blurring, particularly in the edges of k-space where shorter repetition times are used. To address potential resolution loss from T1 blurring, optimal filter methods may be employed during image reconstruction. These filter methods may include filters based on neural networks, which can be trained to mitigate the effects of T1 blurring while preserving image quality.

The transition functions 27 and 27' represent examples of how the repetition time can be varied across k-space. The specific shape, dependencies and parameters of the transition function may be adjusted based on the imaging application, desired contrast, and acquisition time constraints.

Independent of the grammatical term usage, individuals with male, female or other gender identities are included within the term.

## Claims

1. Computer-implemented method for parameterizing a gradient echo, GRE, data acquisition in magnetic resonance imaging, MRI, wherein,
- a predefined data acquisition shot structure (17) for GRE data acquisition is received;
- a first set of parameters (18a) for parameterizing the data acquisition shot structure (17) in a k-space center is received;
- a second set of parameters (18b) for parameterizing the data acquisition shot structure (17) at a k-space edge is received;
- a transition function (20, 27, 27') specifying a transition from the first set of parameters (18a) to the second set of parameters (18b) is computed, wherein the transition function (20, 27, 27') assigns a respective set of parameters for parameterizing the data acquisition shot structure (17) to each k-space segment of a plurality of k-space segments to be sampled according to at least one predefined transition scheme (19);
- the transition function (20, 27, 27') is computed such that it assigns the first set of parameters (18a) to a k-space segment corresponding to the k-space center and assigns the second set of parameters (18b) to a k-space segment corresponding to the k-space edge;
- a pulse sequence (21) for controlling an MRI system (1) to carry out the GRE data acquisition is generated, the pulse sequence (21) comprising a plurality of data acquisition shots (23a, 23b, 23c, 23d), each data acquisition shot (23a, 23b, 23c, 23d) being designed to sample at least one of the plurality of k-space segments according to the data acquisition shot structure (17) parameterized according to the transition function (20, 27, 27').

2. Computer-implemented method according to claim 1, wherein the first set of parameters (18a), the second set of parameters (18b) and the set of parameters assigned by the transition function (20, 27, 27') comprise at least one respective timing parameter for the data acquisition shot structure (17).

3. Computer-implemented method according to claim 2, wherein the at least one timing parameter comprises
- at least one echo time; and/or
- a repetition time; and/or
- an inversion time; and/or
- a dead time; and/or
- an echo train time corresponding to an echo train length.

4. Computer-implemented method according to one of the preceding claims, wherein the first set of parameters (18a), the second set of parameters (18b) and the set of parameters assigned by the transition function (20, 27, 27') comprise
- at least one respective flip angle; and/or
- at least one respective number of echoes corresponding to an echo train length.

5. Computer-implemented method according to one of the preceding claims, wherein the at least one predefined transition scheme (19) comprises a linear transition scheme or a polynomial transition scheme, in particular an at least quadratic or at least cubic transition scheme, or an exponential transition scheme.

6. Computer-implemented method according to one of the preceding claims, wherein
- an intermediate set of parameters for parameterizing the data acquisition shot structure (17) at an intermediate k-space segment, which is different from the k-space center and different from the k-space edge, is received; and
- the transition function (20, 27, 27') is computed to specify a transition from the first set of parameters (18a) to the intermediate set of parameters and from the intermediate set of parameters to the second set of parameters (18b) such that the transition function (20, 27, 27') assigns the intermediate set of parameters to the intermediate k-space segment.

7. Computer-implemented method according to one of the preceding claims, wherein each k-space segment of the plurality of k-space segments is a k-space line along a frequency encoding direction of the k-space.

8. Computer-implemented method according to claim 7, wherein the transition function (20, 27, 27') is a function of a k-space coordinate along a slice selection direction of the k-space.

9. Computer-implemented method according to claim 7, wherein
- the transition function (20, 27, 27') is a function of a k-space radius in a plane of the k-space perpendicular to the frequency encoding direction; and/or
- the transition function (20, 27, 27') is a function of a polar angle in the plane of the k-space perpendicular to the frequency encoding direction.

10. Computer-implemented method according to one of the preceding claims, wherein a third set of parameters for parameterizing the data acquisition shot structure (17) at a further k-space edge is received and
- the transition function (20, 27, 27') is computed to specify a transition from the second set of parameters (18b) to the third set of parameters, wherein the transition function (20, 27, 27') assigns the third set of parameters to a k-space segment corresponding to the further k-space edge; or
- the transition function (20, 27, 27') is computed to specify a transition from the first set of parameters (18a) to the third set of parameters, wherein the transition function (20, 27, 27') assigns the third set of parameters to a k-space segment corresponding to the further k-space edge.

11. Computer-implemented method according to one of the preceding claims, wherein
- the transition assigns a first parameter of the respective set of parameters to each k-space segment of the plurality of k-space segments according to a first transition scheme of the at least one predefined transition scheme (19); and
- the transition assigns a second parameter of the respective set of parameters to each k-space segment of the plurality of k-space segments according to a second transition scheme of the at least one predefined transition scheme (19), wherein the second transition scheme is different from the first transition scheme.

12. Method for controlling an MRI system (1) to carry out a GRE data acquisition, wherein a computer-implemented method according to one of the preceding claims is carried out and the MRI system (1) is controlled to apply the pulse sequence (21).

13. Data processing system (16), which is adapted to carry out a computer-implemented method according to one of claims 1 to 11.

14. MRI system (1) comprising a data processing system (16) according to claim 13 and a controller (15), which is configured to control the MRI system (1) to apply the pulse sequence (21).

15. Computer program product comprising
- instructions, which, when executed by a data processing system (16), cause the data processing system (16) to carry out a computer-implemented method according to one of claims 1 to 11; and/or
- further instructions, which, when executed by an MRI system (1) according to claim 14, cause the MRI system (1) to carry out a method according to claim 12.
